Europäisches Patentamt

European Patent Office

Office européen des brevets

(19)

(11) Veröffentlichungsnummer: **0 028 388**

**A1**

(12) **EUROPÄISCHE PATENTANMELDUNG**

(21) Anmeldenummer: 80106614.3

(22) Anmeldetag: 29.10.80

(51) Int. Cl.³: **G 01 R 11/02**

(30) Priorität: 31.10.79 DE 2943925

(43) Veröffentlichungstag der Anmeldung:
13.05.81 Patentblatt 81/19

(84) Benannte Vertragsstaaten:
AT BE CH LI NL SE

(71) Anmelder: Licentia Patent-Verwaltungs-GmbH
Theodor-Stern-Kai 1
D-6000 Frankfurt/Main 70(DE)

(72) Erfinder: Hoffmann, Horst
Schulstrasse 60
D-3250 Hameln 5(DE)

(72) Erfinder: Joachim, Wolfgang, Dipl.-Ing.
Auf der Höhe 1
D-3253 Hess.-Oldendorf 2(DE)

(72) Erfinder: Froböse, Klaus, Ing. grad.
Ilphulweg 33
D-3250 Hameln 1(DE)

(74) Vertreter: Langer, Karl-Heinz, Dipl.-Ing. et al,
Licentia Patent-Verwaltungs-GmbH Theodor-Stern-Kai
1
D-6000 Frankfurt/Main 70(DE)

(54) Elektronischer Impulsgeber für einen Elektrizitätszähler.

(57) Der Impulsgeber hat einen Oszillatorbaustein (3), dessen Frequenz durch einen aus Induktivität (1a) und Kapazität gebildeten Parallelschwingkreis bestimmt ist und der hochfrequente Schwingungen erzeugt, die nach Gleichrichtung einem Schwellwertschalter zugeführt werden. Der Parallelschwingkreis wird durch an der Induktivität (1a) vorbeilaufende metallische Stege oder Zähne (6a) einer mit der Zählerläuferachse (5) umlaufenden Abtastscheibe (6) bei Annäherung bedämpft. Die passiven Bauteile des Parallelschwingkreises sind innerhalb des Zählergehäuses (4) untergebracht, während der Oszillatorbaustein (3) mit der aktiven Elektronik getrennt davon außerhalb des plombierten Zählergehäuses (4) im oder am Klemmenblock (9) angeordnet ist.

./...

Croydon Printing Company Ltd.

Fig. 2

Licentia Patent-Verwaltungs-G.m.b.H.
D-6000 Frankfurt 70, Theodor-Stern-Kai 1

SE2-HM FH 79/23
spa-wö                                    17. Juli 1980

"Elektronischer Impulsgeber für einen Elektrizitätszähler"

Die Erfindung bezieht sich auf einen elektronischen Impulsgeber für einen Elektrizitätszähler mit einem Oszillatorbaustein, dessen Frequenz durch einen aus Induktivität und Kapazität gebildeten Parallelschwingkreis bestimmt ist und der hochfrequente Schwingungen erzeugt, die nach Gleichrichtung einem Schwellwertschalter zugeführt werden und bei dem der Parallelschwingkreis durch an der Induktivität vorbeilaufende metallische Stege oder Zähne einer mit der Zählerläuferachse umlaufenden Abtastscheibe bei Annäherung bedämpft wird.

Derartige Impulsgeber sind in ihrem Aufbau bekannt und werden in Impulsgeberzähler eingebaut, die wiederum zur Ermittlung des Verbrauchs und der in Anspruch genommenen mittleren Leistung im Rahmen von Fernzähl-,

- 2 -

0028388

Registrier- und Datenverarbeitungsaufgaben in Anlagen größerer Abnehmer zum Einsatz kommen. Der Nachteil bei diesen Impulsgeberzählern ist, daß die gesamte Elektronik sich innerhalb des plombierten Zählergehäuses befindet und damit bei einer Reparatur an der Elektronik eine erneute Beglaubigung des Elektrizitätszählers erforderlich wird. Ohne einen Eingriff in das plombierte Zählergehäuse beträgt beispielsweise für Haushaltszähler die Eichgültigkeitsdauer zur Zeit zunächst sechzehn Jahre. Bei Stichprobennachbeglaubigungen im Zeitraum von vier Jahren kann die Betriebszeit sogar ein Mehrfaches dieses Zeitraumes betragen. Ob derartige, aus elektronischen Bauelementen und Bausteinen aufgebaute Impulsgeber über einen derartigen Zeitraum einwandfrei arbeiten, ist mit letzter Sicherheit nicht vorauszusagen.

Der Erfindung liegt die Aufgabe zugrunde, die für den Einsatz in Haushalten vorgesehenen Elektrizitätszähler so auszugestalten, daß mit geringem Aufwand die Möglichkeit geschaffen wird, bei Bedarf Informationen über den zeitlichen Verbrauch abzurufen, wobei die jetzige Eichgültigkeitsdauer erhalten bleiben soll.

Diese Aufgabe wird erfindungsgemäß dadurch gelöst, daß die passiven Bauteile des Parallelschwingkreises innerhalb des Zählergehäuses untergebracht sind, während der Oszillatorbaustein mit der aktiven Elektronik getrennt davon außerhalb des plombierten Zählergehäuses im oder am Klemmenblock angeordnet ist.

Die Erfindung ist insofern vorteilhaft, als für zukünftige Aufgaben leistungsbezogener Erfassung und Verrechnung elektrischer Energie im Haushalt und Kleingewerbe schon bei den jetzt zu bauenden Elektrizitätszählern eine Option hierauf mit sehr geringen Vorleistungen erhalten wird. In die mit Impulsgebern auszurüstenden Elektrizitätszähler braucht vorläufig nur der passive Teil mit der Induktivität und der Abtastscheibe eingebaut zu werden, während die aktive Elektronik des Impulsgebers ohne Verletzung der Eichplomben gegebenenfalls auch nachgerüstet werden kann. Der passive Teil ist billig herstellbar und aufgrund seiner hohen Zuverlässigkeit wird durch den Einbau die Eichgültigkeitsdauer des Elektrizitätszählers nicht gefährdet. Ein weiterer Vorteil ist, daß bei einem Elektrizitätszähler mit komplettem Impulsgeber der weniger zuverlässige außerhalb des plombierten Zählergehäuses untergebrachte aktive Teil bei Ausfall der Elektronik leicht ausgetauscht werden kann ohne die Eichplomben zu verletzen.

Vorteilhafte Ausgestaltungen der Erfindung sind Gegenstände der Unteransprüche. Anhand der Zeichnung sei die Erfindung nachstehend an einem Ausführungsbeispiel näher erläutert.

Fig. 1 zeigt ein Blockschaltbild des elektronischen Impulsgebers und in

Fig. 2 ist die Anordnung des Impulsgebers in einem Elektrizitätszählergehäuse vereinfacht dargestellt.

Der elektronische Impulsgeber hat einen aus einer Induktivität 1 und Kapazität 2 gebildeten Parallelschwingkreis, der über Eingänge $E_1$, $E_2$, mit einem Oszillatorbaustein 3 verbunden ist. Weitere Anschlüsse des Oszillatorbausteines dienen zur Versorgung mit der extern zugeführten Betriebsspannung $U_B$, während an einem Ausgang A die Zählimpulse für die Weiterverarbeitung in einem nachgeschalteten nicht dargestellten Fernzählgerät anstehen.

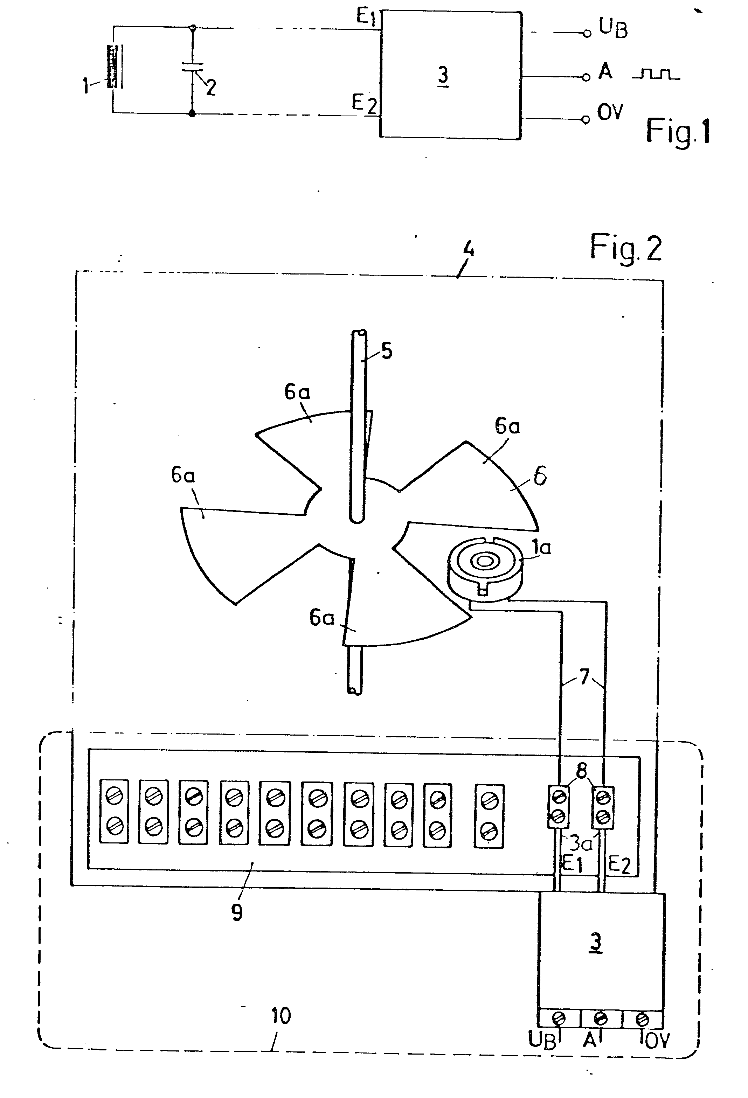

Die Arbeitsweise des Impulsgebers ist folgendermaßen: Der Oszillatorbaustein erzeugt auf bekannte Art hochfrequente Schwingungen, die gleichgerichtet und einem Schwellwertschalter zugeführt werden. Durch Veränderung der Güte des Schwingkreises wird die Schwingungsamplitude gedämpft, so daß der Schwellwertschalter aufgrund seines festgelegten Pegels anspricht und ein verändertes Ausgangssignal abgibt. Die Veränderung der Güte des Schwingkreises wird nun durch eine Anordnung erreicht, wie sie in Fig. 2 gezeigt ist.

Im durch Strichpunktlinien angedeuteten Zählergehäuse 4, das vom Hersteller des Elektrizitätszählers nach der Einstellung und Beglaubigung plombiert wird, befindet sich eine mit der Zählerläuferachse 5 umlaufende metallische Abtastscheibe 6. Diese ist mit Stegen bzw. Zähnen 6a versehen, deren Zahl im Ausführungsbeispiel mit 4 gewählt ist. Letztere gleiten über einen Schalenkern 1a, der der Induktivität 1 entspricht und verändern bei Annäherung die Güte des Schwingkreises, so daß der Impulsgeber im gewählten Beispiel vier Ausgangsimpulse pro Läuferumdrehung abgibt. Vom Schalenkern führen zwei Anschlußleitungen 7 aus dem plombierten Zählergehäuse heraus auf zwei Zusatzklemmen 8, die im Klemmenblock 9 des Elektrizitätszählers untergebracht sind. Der Oszillatorbaustein 3 mit den aktiven Bauelementen ist als vergossener Block ausgebildet und mit zwei Anschlußstiften 3a versehen, mit denen er in die Zusatzklemmen 8 steckbar ist und am Klemmenblock zur Anlage kommt. Letzterer und der Oszillatorbaustein werden durch einen lediglich mit Strichlinien angedeuteten Klemmendeckel 10 abgedeckt und sind so jederzeit durch einen zugelassenen Elektrofachmann zugänglich. ohne daß die Eichgültigkeit des Elektrizitätszählers davon beeinflußt wird.

Der als Schwingkreiskapazität wirkende Kondensator 2 kann sowohl innerhalb des Zählergehäuses als auch mit den aktiven Bauteilen im Block des Oszillatorbausteines untergebracht werden. Damit werden als Vorleistungen beim Bau des Elektrizitätszählers nur die gezahnte Abtastscheibe 6 und der Schalenkern 1a mit den auf die Zusatzklemmen 8 geführten Anschlußleitungen 7 erforderlich. Die Zuverlässigkeit dieser Bauteile liegt so hoch, daß die Eichgültigkeitsdauer des Elektrizitätszählers gewährleistet ist.

Der Oszillatorbaustein 3 mit der weniger zuverlässigen Elektronik, die zudem ein Mehrfaches der passiven Bauteile kostet, kann dagegen bei derart vorbereiteten Elektrizitätszählern auch nachträglich angebaut werden, wenn sich in der Zukunft die Notwendigkeit für eine Energiesteuerung ergibt. Gleichzeitig mit dem Anschluß des jeweiligen Elektrizitätszählers an ein Fernzählgerät läßt sich dann der aktive Teil des elektronischen Impulsgebers im Zähler installieren. Anstelle der in Fig. 2 gewählten Anordnung kann im Klemmenblock auch eine Kammer ausgespart werden, die so bemessen ist, daß der als vergossener Block ausgebildete Oszillatorbaustein direkt steckbar im Klemmenblock aufgenommen werden kann. Um Fehlanschlüsse bei fehlendem Oszillatorbaustein zu vermeiden, sind Mittel zum Verschließen der Zusatzklemmen vorgesehen, insbesondere um zu verhindern, daß irrtümlicherweise spannungsführende Leitungen angeklemmt werden. Zum externen Anschluß des Oszillatorbausteines ist dieser mit Klemmen, Kabelschuhen, Kontaktmessern oder dgl. versehen.

Patentansprüche:

1. Elektronischer Impulsgeber für einen Elektrizitätszähler mit einem Oszillatorbaustein (3), dessen Frequenz durch einen aus Induktivität (1) und Kapazität (2) gebildeten Parallelschwingkreis bestimmt ist und der hochfrequente Schwingungen erzeugt, die nach Gleichrichtung einem Schwellwertschalter zugeführt werden und bei dem der Parallelschwingkreis durch an der Induktivität vorbeilaufende metallische Stege oder Zähne einer mit der Zählerläuferachse (5) umlaufenden Abtastscheibe (6) bei Annäherung bedämpft wird, d a d u r c h   g e k e n n z e i c h n e t , daß die passiven Bauteile (1, 2, 6) des Parallelschwingkreises innerhalb des Zählergehäuses (4) untergebracht sind, während der Oszillatorbaustein (3) mit der aktiven Elektronik getrennt davon außerhalb des plombierten Zählergehäuses (4) im oder am Klemmenblock (9) angeordnet ist.

2. Elektronischer Impulsgeber nach Anspruch 1 dadurch gekennzeichnet, daß lediglich die als Schalenkern (1a) ausgebildete Induktivität (1) mit der auf sie einwirkenden Abtastscheibe (6) im Zählergehäuse (4) untergebracht sind, aus dem die erforderlichen Anschlußleitungen (7) auf Zusatzklemmen (8) des Klemmenblockes (9) führen und daß die aktiven Bauteile des Oszillatorbausteines (3) als vergossener Block mit Anschlußstiften (3a) unterhalb des Klemmendeckels (10) daran befestigt sind.

3. Elektronischer Impulsgeber nach Anspruch 1 und 2, dadurch gekennzeichnet, daß im Klemmenblock (9) eine besondere Kammer zum Einbau des aktiven Teiles des Oszillatorbausteines (3) ausgebildet ist.

4. Elektronischer Impulsgeber nach Anspruch 1 bis 3, dadurch gekennzeichnet, daß zwecks Vermeidung eines irrtümlichen Anschlusses die Zusatzklemmen (8) bei Betrieb des Zählers ohne Oszillatorbaustein (3) durch geeignete Mittel verschlossen sind.

5. Elektronischer Impulsgeber nach Anspruch 1 bis 3, dadurch gekennzeichnet, daß der Oszillatorbaustein zum externen Anschluß mit Klemmen, Kabelschuhen, Kontaktmessern und dgl. versehen ist.

1/1

0028388

Fig.1

Fig.2

Europäisches
Patentamt

**EUROPÄISCHER RECHERCHENBERICHT**

**0028388**
Nummer der Anmeldung

EP 80106614.3

| | EINSCHLÄGIGE DOKUMENTE | | KLASSIFIKATION DER ANMELDUNG (Int Cl ) |
|---|---|---|---|
| Kategorie | Kennzeichnung des Dokuments mit Angabe, soweit erforderlich, der maßgeblichen Teile | betrifft Anspruch | |
| A | <u>AT - B - 321 407</u> (LANDIS & GYR)<br>* Seite 2, Zeilen 18-21; Seite 3, Zeilen 1-5; Fig.1 *<br>-- | 1 | G 01 R 11/02 |
| A | <u>AT - B - 256 983</u> (LANDIS & GYR)<br>* Fig.1,2; Seite 1, Zeilen 8-20 *<br>-- | 1 | |
| A | <u>DE - A1 - 2 712 918</u> (LICENTIA)<br>* Fig.1,2; Seite 3, Absatz 2 *<br>-- | 1,5 | |
| A | <u>DE - A1 - 2 516 759</u> (SIEMENS)<br>* Fig.1; Seite 2, Absatz 2 *<br>---- | 1,3 | RECHERCHIERTE SACHGEBIETE (Int Cl )<br><br>G 01 D 4/00<br>G 01 R 11/00 |

| | | | | |
|---|---|---|---|---|
| X | Der vorliegende Recherchenbericht wurde für alle Patentansprüche erstellt | | | |
| Recherchenort<br>WIEN | | Abschlußdatum der Recherche<br>20-01-1981 | Prüfer<br>KUNZE | |

EPA form 1503.1   06.78